# EUROPEAN PATENT APPLICATION

(11) **EP 2 915 597 A1**
(43) Date of publication of application: **09.09.2015**
(21) Application number: 15157488.6
(22) Date of filing: 04.03.2015
(51) Int. Cl.: B07C 5/342, B25J 9/16, G01R 31/28, G01N 21/956, G07C 3/14, H01L 21/67, H01L 21/68, H01L 21/683, H05K 13/08, G01N 21/95, H01L 21/66

(54) **Programmable digital machine vision inspection system**

(30) Priority: 05.03.2014 CN 201410079264
(71) Applicant: Tyco Electronics (Shanghai) Co., Ltd., Shanghai 200233 (CN); Tyco Electronics Corporation, Berwyn, PA 19312 (US); Shenzhen AMI Technology Co. Ltd, Shenzhen, Guangdong 518108 (CN)
(72) Inventor: Deng, Yingcong, Shanghai (CN); Zhang, Dandan, Shanghai (CN); Lu, Robert Francisco-Yi, Bellevue, WA 98006 (US); Hu, Lvhai, Shanghai (CN); Zeng, Zinglong, Shenzhen, Guangdong Province (CN)
(74) Representative: Grünecker Patent- und Rechtsanwälte PartG mbB

(57) **Abstract**

The present invention discloses a programmable digital machine vision inspection system, comprising: a programmable automatic feeding system configured to supply elements to be inspected; a programmable robot system comprising a robot and a first vision system, wherein the robot configured to grip the element supplied by the programmable automatic feeding system and transmit the gripped element into an inspection area under the guidance of the first vision system; and a programmable inspection system comprising a second vision system configured to identify features of the elements transmitted into the inspection area and determine whether the element is a qualified product based on the identified features. If the element is determined to be a qualified product, the robot places the element into a first container for receiving the qualified product; If the element is determined to be an unqualified product, the robot places the element into a second container for receiving the unqualified product. The programmable digital machine vision inspection system is adapted to inspect different types of elements, and switching between inspection operations of different types of elements is very quickly.

## Description

### CROSS-REFERENCE TO RELATED APPLICATION

This application claims the benefit of Chinese Patent Application No. 201410079264.0 filed on March 5, 2014 in the State Intellectual Property Office of China, the whole disclosure of which is incorporated herein by reference.

### BACKGROUND OF THE INVENTION

### Field of the Invention

The present invention relates to a programmable digital machine vision inspection system, more particularly, relates to a programmable digital machine vision inspection system for inspecting complex and tiny electronic components.

### Description of the Related Art

In prior art, inspecting complex and tiny elements, for example, electronic components, generally is performed by manual. Firstly, an operator picks up an electronic component by a clamp and places the electronic component on an inspection table in an inspection area of a vision inspection system. Then, the vision inspection system inspects all surfaces of the electronic component in the inspection area and determines whether the electronic component is a qualified product. If the electronic component is determined as a qualified product, the operator picks up the electronic component by the clamp and places it into a container for receiving the qualified product. If the electronic component is determined as an unqualified product, the operator picks up the electronic component by the clamp and places it into a container for receiving the unqualified product. In this way, the inspection and classification of the electronic component is finished.

In the prior art, there also is provided many production apparatus having the vision inspection function, that is, the production apparatus can achieve the inspection of the elements on line. These production apparatus can automatically feed the elements, automatically inspect the elements and automatically remove the elements from the inspection area. However, these production apparatus in the prior art can inspect only one or a few kinds of elements.

In addition, in the prior art, there is also provided some individual inspection apparatus for inspecting the elements in an off line manner. However, these individual inspection apparatus are specially used to inspect one kind or one type of elements, and cannot inspect different kinds or types of elements by digital program. Furthermore, in this vision inspection system, feeding and removing of the elements are performed by manual, decreasing the inspection efficiency.

In addition, in the vision inspection system in the prior art, a distance between the camera and the element to be inspected cannot be freely adjusted according to the size of the element to be inspected. Thereby, the accuracy to inspect some extremely small electronic components is limited.

### SUMMARY OF THE INVENTION

The present invention has been made to overcome or alleviate at least one aspect of the above mentioned disadvantages.

According to an object of the present invention, there is provided a programmable digital machine vision inspection system, wherein entire inspection process is controlled and automatically performed by program without requiring any manual operation, improving the inspection efficiency.

According to another object of the present invention, there is provided a programmable digital machine vision inspection system, wherein distances between a camera and an element to be inspected in various directions can be adjusted based on size of the element, improving the inspection accuracy.

According to an aspect of the present invention, there is provided a programmable digital machine vision inspection system, comprising: a programmable automatic feeding system configured to supply elements to be inspected; a programmable robot system comprising a robot and a first vision system, wherein the robot configured to grip the element supplied by the programmable automatic feeding system and transmit the gripped element into an inspection area under the guidance of the first vision system; and a programmable inspection system comprising a second vision system configured to identify features of the elements transmitted into the inspection area and determined whether the element is a qualified product based on the identified features. If the element is determined to be a qualified product, the robot places the element into a first container for receiving the qualified product; If the element is determined to be an unqualified product, the robot places the element into a second container for receiving the unqualified product.

According to an exemplary embodiment of the present invention, the programmable robot system further comprises a tool cabinet, and the robot is configured to select a suitable tool from the tool cabinet and automatically replace a current tool with the selected tool thereon.

According to another exemplary embodiment of the present invention, the first vision system comprises a first camera, and the first camera is configured to move in at least one direction, so as to adjust a distance between the first camera and the element to be inspected and a distance between the first camera and the robot.

According to another exemplary embodiment of the present invention, the first camera is mounted on a movable arm moving in a vertical direction.

According to another exemplary embodiment of the present invention, the first vision system further comprises a first light source mounted on the movable arm and moving together with the first camera.

According to another exemplary embodiment of the present invention, the first light source is configured to automatically control and adjust intensity and color of a light emitted therefrom by program.

According to another exemplary embodiment of the present invention, the second vision system comprises at least one second camera, each of which is configured to be capable of moving in at least one direction to adjust a distance between the second camera and the element to be inspected.

According to another exemplary embodiment of the present invention, the second vision system comprises a plurality of second cameras for simultaneously identifying features of different surfaces of the element transmitted into the inspection area.

According to another exemplary embodiment of the present invention, the plurality of second cameras comprising: a first one having an optical axis extending in a first direction; a second one having an optical axis extending in a second direction perpendicular to the first direction; and a third one having an optical axis extending in a third direction perpendicular to the first direction and the second direction.

According to another exemplary embodiment of the present invention, the plurality of second cameras further comprising: a fourth one having an optical axis extending in a fourth direction different from any one of the first direction, the second direction and the third direction.

According to another exemplary embodiment of the present invention, each of the second cameras is mounted on an individual moving mechanism configured to be movable in the first direction, the second direction and the third direction, so as to move the second camera in the first direction, the second direction and the third direction.

According to another exemplary embodiment of the present invention, each of the individual moving mechanisms comprising: a first movable arm configured to be movable in the first direction; a second movable arm mounted on the first movable arm and configured to be movable in the second direction; and a third movable arm mounted on the second movable arm and configured to be movable in the third direction.

According to another exemplary embodiment of the present invention, the second camera is mounted on the first movable arm or the third movable arm of the individual moving mechanism.

According to another exemplary embodiment of the present invention, the first direction is a first horizontal direction; the second direction is a second horizontal direction perpendicular to the first horizontal direction; and the third direction is a vertical direction perpendicular to the first horizontal direction and the second horizontal direction.

According to another exemplary embodiment of the present invention, the second vision system further comprises a plurality of second light sources corresponding to the plurality of second cameras, respectively, and each of the second light sources is mounted on the respective moving mechanism to move with the respective second camera.

According to another exemplary embodiment of the present invention, each of the second light sources is configured to be capable of automatically controlling and adjusting intensity and color of a light emitted therefrom by program.

According to another exemplary embodiment of the present invention, the programmable inspection system further comprises a rotatable platform on which the element gripped by the robot is placed; and the rotatable platform is configured to be rotatable about the vertical direction to change an orientation of the element placed thereon.

According to another exemplary embodiment of the present invention, the rotatable platform comprises a plurality of vacuum suction nozzles configured to suck and position the elements placed on the rotatable platform.

In the above various embodiments of the present invention, entire inspection process is controlled and automatically performed by program without requiring any manual operation, improving the inspection efficiency. In some embodiments, distances between the camera and the element to be inspected in various directions can be adjusted based on the size of the element, improving the inspection accuracy.

The programmable digital machine vision inspection system according to the embodiments of the present invention is configured to an off-line individual apparatus independent of a production line and a production apparatus. The programmable digital machine vision inspection system is adapted to inspect different types of elements, and switching between inspection operations of different types of elements is very quickly. Furthermore, the entire inspection system is automatically controlled by program without requiring any manual operation, improving the inspection efficiency.

### BRIEF DESCRIPTION OF THE DRAWINGS

The above and other features of the present invention will become more apparent by describing in detail exemplary embodiments thereof with reference to the accompanying drawings, in which:
Fig.1 is an illustrative view of function modules of a programmable digital machine vision inspection system according to an exemplary embodiment of the present invention;
Fig.2 is a top view of the programmable digital machine vision inspection system of Fig.1;
Fig.3 is an illustrative perspective view of a programmable automatic feeding system in the programmable digital machine vision inspection system of Fig.1;
Fig.4 is an illustrative perspective view of a first vision system of a programmable robot system in the programmable digital machine vision inspection system of Fig.1;
Fig.5 is an illustrative perspective view of a first sub inspection system of a second vision system of the programmable inspection system in the programmable digital machine vision inspection system of Fig.1;
Fig.6 is an illustrative perspective view of a second sub inspection system of the second vision system of the programmable inspection system in the programmable digital machine vision inspection system of Fig.1;
Fig.7 is an illustrative perspective view of a third sub inspection system of the second vision system of the programmable inspection system in the programmable digital machine vision inspection system of Fig.1; and
Fig.8 is an illustrative perspective view of a rotatable platform of the programmable inspection system in the programmable digital machine vision inspection system of Fig.1.

### DETAILED DESCRIPTION OF PREFERRED EMBODIMENTS OF THE IVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present invention, there is provided a programmable digital machine vision inspection system, comprising: a programmable automatic feeding system for supplying elements to be inspected; a programmable robot system comprising a robot and a first vision system, wherein the robot is constructed to grip the element supplied by the programmable automatic feeding system and transmit the gripped element into an inspection area under the guidance of the first vision system; and a programmable inspection system comprising a second vision system for identifying features of the elements moved into the inspection area and determining whether the element is a qualified product based on the identified features. If the element is determined to be a qualified product, the robot places the element into a first container for receiving the qualified product; If the element is determined to be an unqualified product, the robot places the element into a second container for receiving the unqualified product.

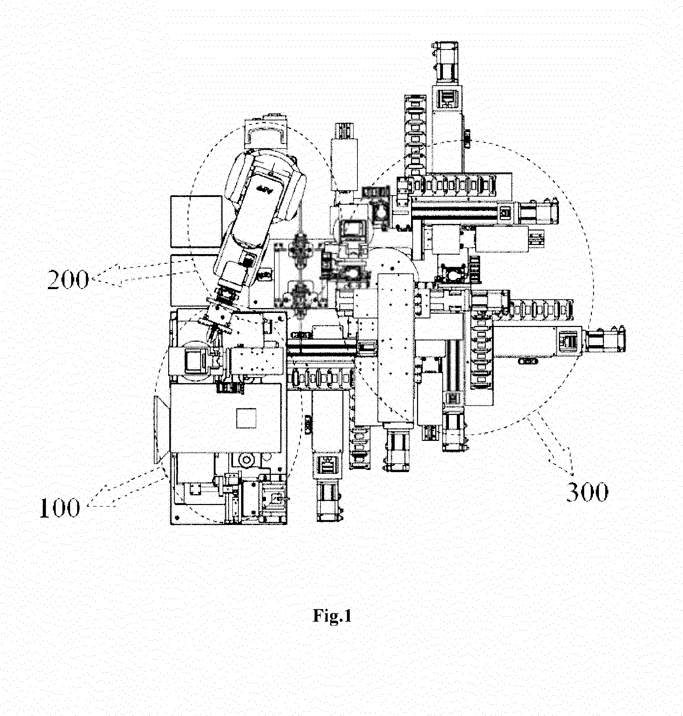

Fig.1 is an illustrative view of function modules of a programmable digital machine vision inspection system according to an exemplary embodiment of the present invention.

In an exemplary embodiment of the present invention, there is disclosed a programmable digital machine vision inspection system. As shown in Fig.1, the programmable digital machine vision inspection system mainly comprises three function modules, the first one of which is a programmable automatic feeding system 100, the second one of which is a programmable robot system 200, and the third one of which is a programmable inspection system 300.

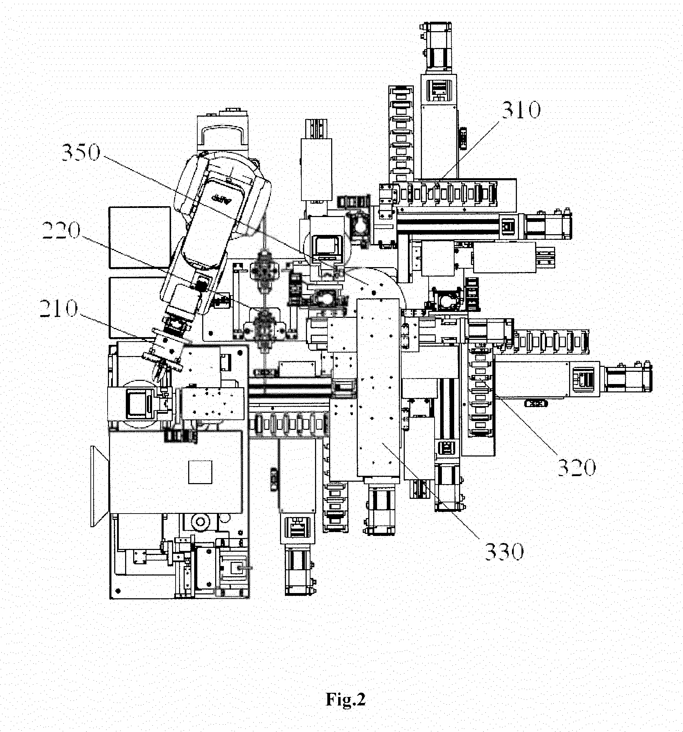

Fig.2 is a top view of the programmable digital machine vision inspection system of Fig.1.

As shown in Figs.1-2, the programmable automatic feeding system 100 is configured to supply elements (not shown) to be inspected. The programmable robot system 200 comprises a robot 210 and a first vision system (to be described later). The robot 210 is constructed to grip the element supplied by the programmable automatic feeding system 100 and transmit the gripped element into an inspection area (for example, an area on a rotatable platform 350 shown in Fig.2) under the guidance of the first vision system. The programmable inspection system 300 comprises a second vision system (to be described later). The second vision system is configured to identify features of the elements transmitted into the inspection area and determine whether the element is a qualified product based on the identified features. If the element is determined to be a qualified product, the robot 210 places the element into a first container (not shown) for receiving the qualified product. If the element is determined to be an unqualified product, the robot 210 places the element into a second container (not shown) for receiving the unqualified product.

In this way, entire inspection process, including feeding elements, picking up elements, inspecting elements and unloading elements, is automatically controlled and performed by program independent of any manual operation, improving the inspection efficiency.

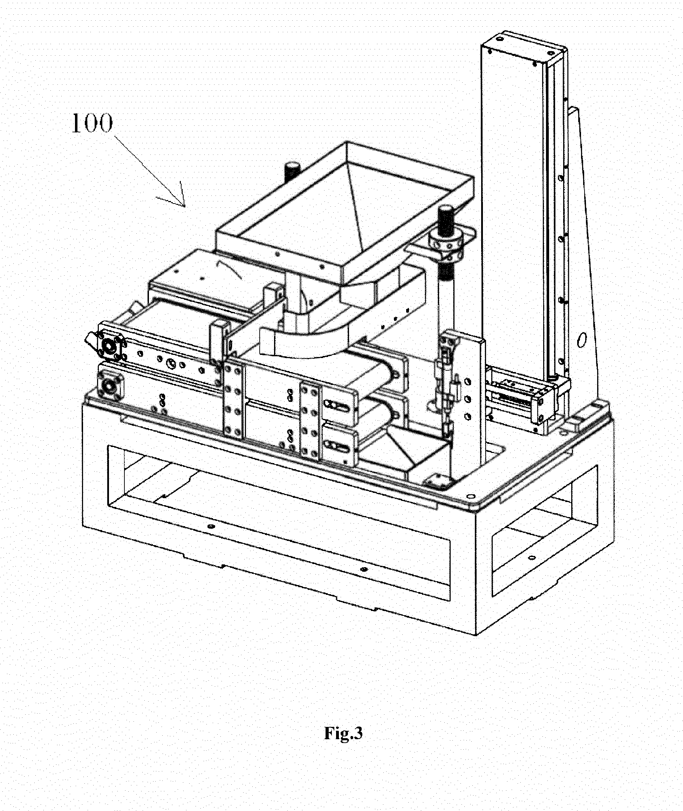

Fig.3 is an illustrative perspective view of the programmable automatic feeding system 100 in the programmable digital machine vision inspection system of Fig.1.

The programmable automatic feeding system 100 may be any suitable programmable automatic feeding system in prior art, for example, a programmable automatic feeding system disclosed in a Chinese patent application No.201310495091.6 filed on October 21, 2013, the whole disclosure of which is incorporated herein by reference.

Please refer to Fig.2 again, the programmable robot system 200 further comprises a tool cabinet 220, and the robot 210 is configured to select a suitable tool from the tool cabinet 220 and automatically replacing a current tool with the selected tool thereon under the guidance of a first vision system. In this way, the robot 210 may grip different kinds or types of elements by replacing different tools.

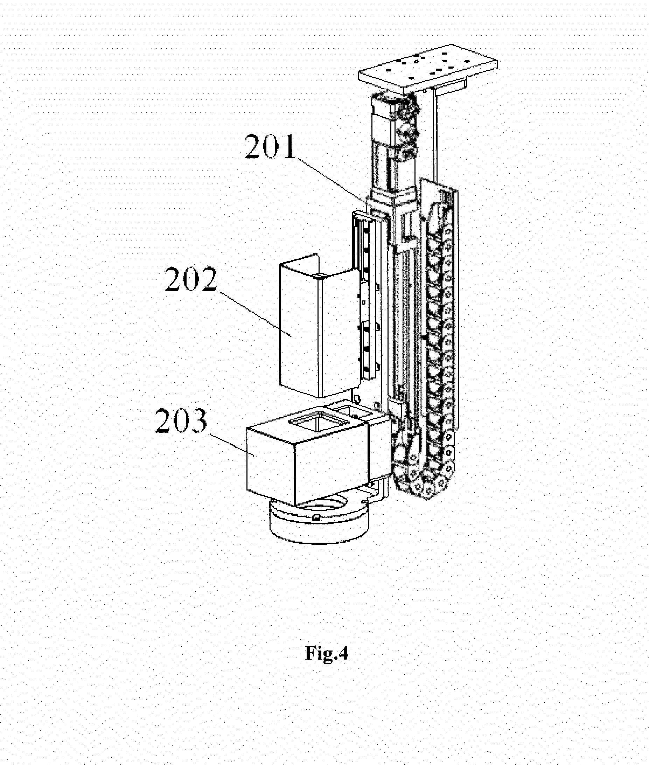

Fig.4 is an illustrative perspective view of a first vision system of the programmable robot system 200 in the programmable digital machine vision inspection system of Fig.1.

As shown in Fig.4, the first vision system may be located above the programmable automatic feeding system 100 shown in Fig.3. In the illustrated embodiment, the first vision system comprises a first camera 202 configured to be movable in at least one direction, so as to adjust a distance between the first camera 202 and the element to be inspected and a distance between the first camera 202 and the robot 210.

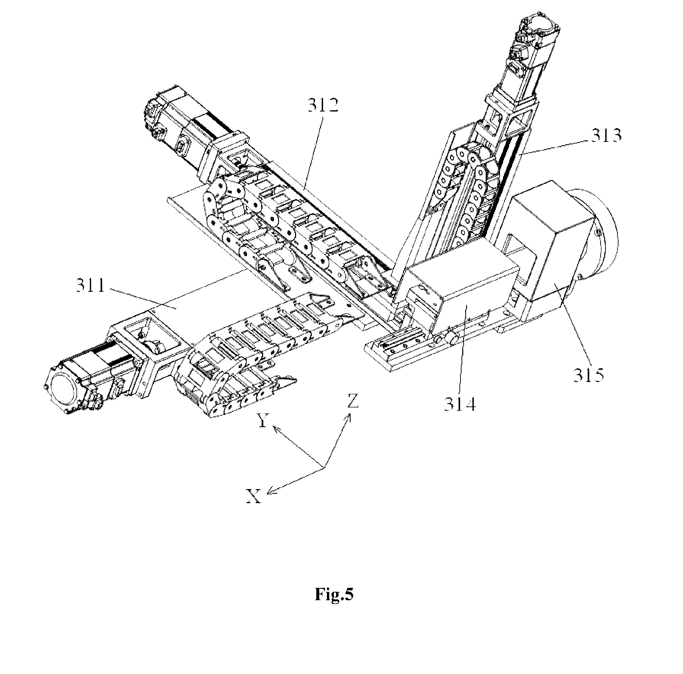

In the illustrated embodiment of Fig.4, the first camera 202 is mounted on a movable arm 201 to move together with the movable arm 201 in a vertical direction Z (see Figs.5-6). But the present invention is not limited to the illustrated embodiment, the first camera 202 may be configured to be capable of moving in at least one of a first horizontal direction X (see Figs.5-6), a second horizontal direction Y (see Figs.5-6) and the vertical direction Z as a second camera shown in Figs.5-7. In another embodiment, the first camera 202 may be configured to be capable of moving in any direction different from the first horizontal direction X, the second horizontal direction Y and the vertical direction Z.

As shown in Fig.4, the first vision system further comprises a first light source 203 mounted on the movable arm 201 and movable together with the first camera 202. The first light source 203 provides illumination for the first camera 202. In an embodiment, the first light source 203 is configured to be capable of automatically controlling and adjusting intensity, color and other property parameters of a light emitted therefrom by program.

Fig.5 is an illustrative perspective view of a first sub inspection system 310 of a second vision system of the programmable inspection system in the programmable digital machine vision inspection system of Fig.1.

As shown in Fig.5, the first sub inspection system 310 comprises: a first movable arm 311 configured to be movable in the first direction X; a second movable arm 312 mounted on the first movable arm 311 and configured to be movable in the second direction Y; a third movable arm 313 mounted on the second movable arm 312 and configured to be movable in the third direction Z; and a second camera 314 mounted on the third movable arm 313. In this way, the second camera 314 is configured to be capable of moving in at least one of the first direction X, the second direction Y and the third direction Z, so as to adjust a distance between the second camera 314 and the element to be inspected.

In the illustrated embodiment, the first direction X is a first horizontal direction; the second direction Y is a second horizontal direction perpendicular to the first horizontal direction; and the third direction Z is a vertical direction perpendicular to the first horizontal direction and the second horizontal direction.

As shown in Fig.5, the first sub inspection system 310 further comprises a second light source 315, corresponding to the second camera 314, mounted on the third movable arm 313 to move together with the corresponding second camera 314. The second light source 315 is configured to provide illumination for the second camera 314. In an embodiment, the second light source 315 is configured to be capable of automatically controlling and adjusting intensity, color and other property parameters of a light emitted therefrom by program.

As shown in Fig.5, the second camera 314 has an optical axis extending in the first horizontal direction X, so as to capture an image of the element in the first horizontal direction X.

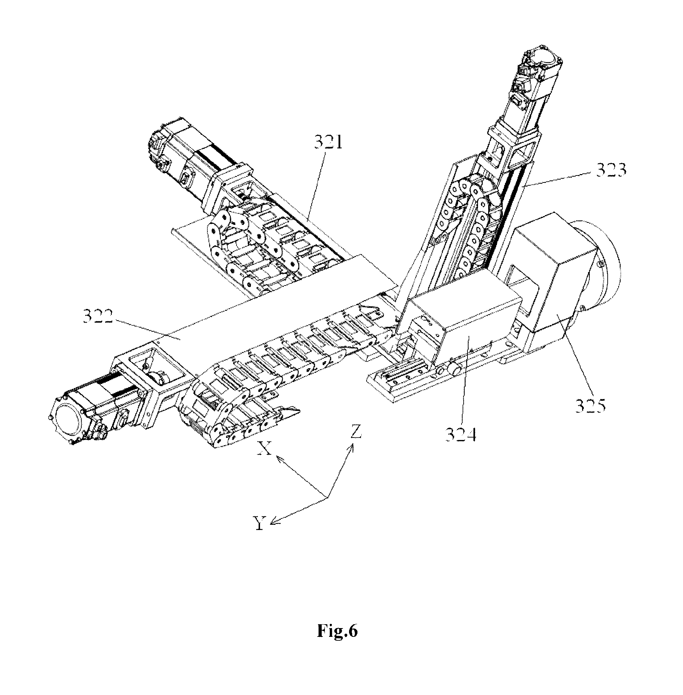

Fig.6 is an illustrative perspective view of a second sub inspection system 320 of the second vision system of the programmable inspection system in the programmable digital machine vision inspection system of Fig.1.

As shown in Fig.6, the second sub inspection system 320 comprises: a first movable arm 321 configured to be movable in the first direction X; a second movable arm 322 mounted on the first movable arm 321 and configured to be movable in the second direction Y; a third movable arm 323 mounted on the second movable arm 312 and configured to be movable in the third direction Z; and a second camera 324 mounted on the third movable arm 323. In this way, the second camera 324 is configured to be capable of moving in at least one of the first direction X, the second direction Y and the third direction Z, so as to adjust a distance between the second camera 324 and the element to be inspected.

As shown in Fig.6, the second sub inspection system 320 further comprises a second light source 325, corresponding to the second camera 324, mounted on the third movable arm 323 to move together with the corresponding second camera 324. The second light source 325 is configured to provide illumination for the second camera 324. In an embodiment, the second light source 325 is configured to be capable of automatically controlling and adjusting intensity, color and other property parameters of a light emitted therefrom by program.

As shown in Fig.6, the second camera 324 has an optical axis extending in the second horizontal direction Y, so as to capture an image of the element in the second horizontal direction Y.

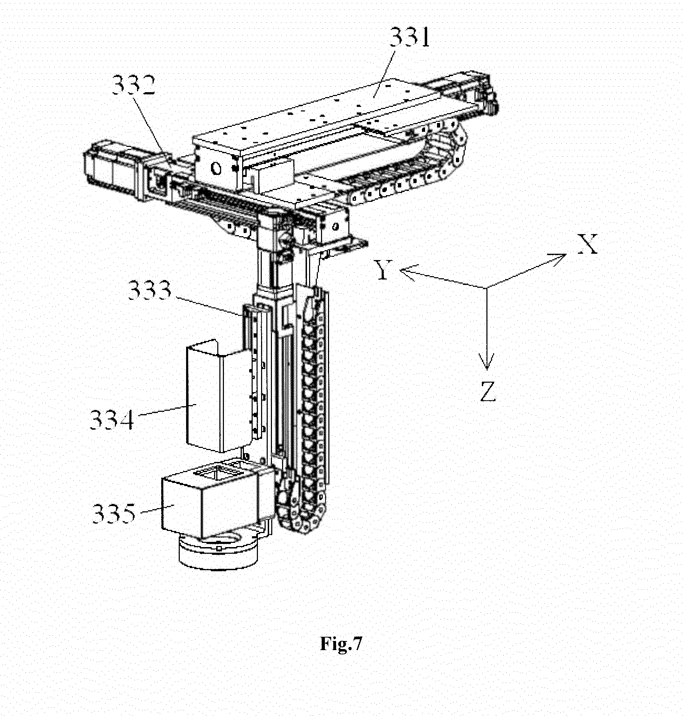

Fig.7 is an illustrative perspective view of a third sub inspection system 330 of the second vision system of the programmable inspection system in the programmable digital machine vision inspection system of Fig.1.

As shown in Fig.7, the third sub inspection system 330 comprises: a first movable arm 331 configured to be movable in the first direction X; a second movable arm 332 mounted on the first movable arm 331 and configured to be movable in the second direction Y; a third movable arm 333 mounted on the second movable arm 332 and configured to be movable in the third direction Z; and a second camera 334 mounted on the third movable arm 333. In this way, the second camera 334 is configured to be capable of moving in at least one of the first direction X, the second direction Y and the third direction Z, so as to adjust a distance between the second camera 334 and the element to be inspected.

As shown in Fig.7, the third sub inspection system 330 further comprises a second light source 335, corresponding to the second camera 334, mounted on the third movable arm 333 to move with the corresponding second camera 334. The second light source 335 is configured to provide illumination for the second camera 334. In an embodiment, the second light source 335 is configured to be capable of automatically controlling and adjusting intensity, color and other property parameters of a light emitted therefrom by program.

As shown in Fig.7, the second camera 334 has an optical axis extending in the vertical direction Z, so as to capture an image of the element in the vertical direction Z.

In this way, the vision inspection system 300 can inspect different surfaces of the element in different directions.

Although it is not shown, in an embodiment of the present invention, the vision inspection system 300 may further comprise a fourth sub inspection system having a second camera with an optical axis extending in a fourth direction different from any one of the first direction X, the second direction Y and the third direction Z. Except for this, the fourth sub inspection system may be configured to be substantially the same as the first, second and third sub inspection systems.

Please be noted that the present invention is not limited to the illustrated embodiments, the vision inspection system 300 may comprise one, two, five or more sub inspection systems.

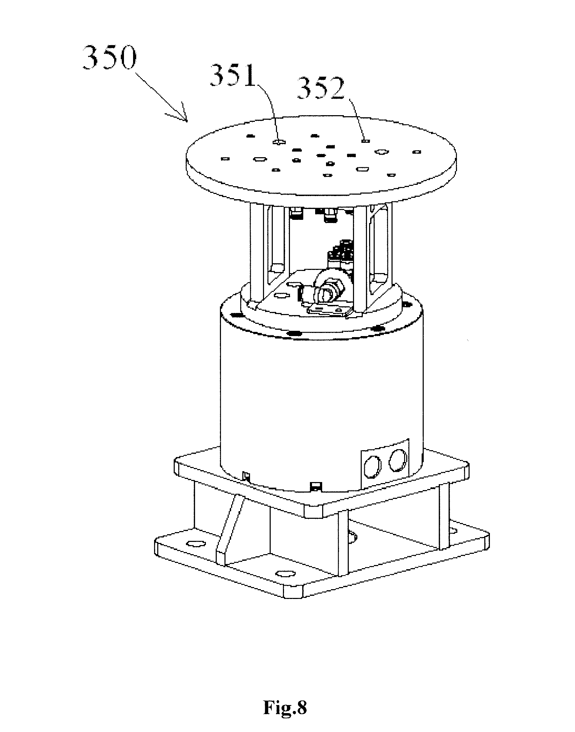

Fig.8 is an illustrative perspective view of a rotatable platform 350 of the programmable inspection system in the programmable digital machine vision inspection system of Fig.1.

As shown in Figs.2 and 8, the programmable inspection system 300 further comprises a rotatable platform 350 mounted in the inspection area. The element gripped by the robot 210 is placed on the rotatable platform 350. The rotatable platform 350 is configured to be rotatable about the vertical direction Z to change an orientation of the element placed thereon.

In an exemplary embodiment of the present invention, the rotatable platform 350 comprises a plurality of vacuum suction nozzles 351, 352 configured to suck and position the elements placed on the rotatable platform 350. The plurality of vacuum suction nozzles 351, 352 may have different sizes and shapes, so as to suck and position elements with different sizes and shapes.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles and spirit of the disclosure, the scope of which is defined in the claims and their equivalents.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. A programmable digital machine vision inspection system, comprising:
a programmable automatic feeding system (100) configured to supply elements to be inspected;
a programmable robot system (200) comprising a robot (210) and a first vision system, wherein the robot (210) is configured to grip the element supplied by the programmable automatic feeding system (100) and transmit the gripped element into an inspection area under the guidance of the first vision system; and
a programmable inspection system (300) comprising a second vision system configured to identify features of the elements transmitted into the inspection area and determine whether the element is a qualified product based on the identified features,
wherein if the element is determined as a qualified product, the robot (210) places the element into a first container for receiving the qualified product, and if the element is determined as an unqualified product, the robot (210) places the element into a second container for receiving the unqualified product.

2. The programmable digital machine vision inspection system according to claim 1, wherein the programmable robot system (200) further comprises a tool cabinet (220), and the robot (210) is configured to select a suitable tool from the tool cabinet (220) and automatically replace a current tool with the selected tool thereon.

3. The programmable digital machine vision inspection system according to claim 2, wherein the first vision system comprises a first camera (202) configured to be movable in at least one direction, so as to adjust the distance between the first camera (202) and the element to be inspected and the distance between the first camera (202) and the robot (210).

4. The programmable digital machine vision inspection system according to claim 3, wherein the first camera (202) is mounted on a movable arm (201) moving in a vertical direction (Z).

5. The programmable digital machine vision inspection system according to claim 4, wherein the first vision system further comprises a first light source (203) mounted on the movable arm (201) and moving together with the first camera (202).

6. The programmable digital machine vision inspection system according to claim 5, wherein the first light source (203) is configured to automatically control and adjust intensity and color of the light emitted therefrom by program control.

7. The programmable digital machine vision inspection system according to claim 2, wherein the second vision system comprises at least one second camera (314, 324, 334), each of which is configured to be movable in at least one direction to adjust the distance between the second camera (314, 324, 334) and the element to be inspected.

8. The programmable digital machine vision inspection system according to claim 7, wherein the second vision system comprises a plurality of second cameras (314, 324, 334) for simultaneously identifying features of different surfaces of the element transmitted into the inspection area.

9. The programmable digital machine vision inspection system according to claim 8, wherein the plurality of second cameras (314, 324, 334) comprising:
a first one (314) having an optical axis extending in a first direction (X);
a second one (324) having an optical axis extending in a second direction (Y) perpendicular to the first direction (X); and
a third one (334) having an optical axis extending in a third direction (Z) perpendicular to the first direction (X) and the second direction (Y).

10. The programmable digital machine vision inspection system according to claim 9, wherein the plurality of second cameras (314, 324, 334) further comprising:
a fourth one having an optical axis extending in a fourth direction different from any one of the first direction (X), the second direction (Y) and the third direction (Z).

11. The programmable digital machine vision inspection system according to claim 10, wherein each of the second cameras (314) is mounted on an individual moving mechanism configured to be movable in the first direction (X), the second direction (Y) and the third direction (Z), so as to move the second camera (314) in the first direction (X), the second direction (Y) and the third direction (Z).

12. The programmable digital machine vision inspection system according to claim 11, wherein each of the individual moving mechanisms comprising:
a first movable arm (311) configured to be movable in the first direction (X);
a second movable arm (312) mounted on the first movable arm (311) and configured to be movable in the second direction (Y); and
a third movable arm (313) mounted on the second movable arm (312) and configured to be movable in the third direction (Z).

13. The programmable digital machine vision inspection system according to claim 12,
wherein the second camera (314) is mounted on the first movable arm (311) or the third movable arm (313) of the individual moving mechanism.

14. The programmable digital machine vision inspection system according to claim 13,
wherein the first direction (X) is a first horizontal direction; the second direction (Y) is a second horizontal direction perpendicular to the first horizontal direction; and the third direction (Z) is a vertical direction perpendicular to the first horizontal direction and the second horizontal direction.

15. The programmable digital machine vision inspection system according to claim 14,
wherein the second vision system further comprises a plurality of second light sources (315, 325, 335) corresponding to the plurality of second cameras (314, 324, 334), respectively, and each of the second light sources (315, 325, 335) is mounted on the respective moving mechanism to move together with the respective second camera (314, 324,334).

16. The programmable digital machine vision inspection system according to claim 15,
wherein each of the second light sources (315, 325, 335) is configured to automatically control and adjust intensity and color of a light emitted therefrom by program.

17. The programmable digital machine vision inspection system according to claim 16,
wherein the programmable inspection system (300) further comprises a rotatable platform (350) on which the element gripped by the robot (210) is placed; and
wherein the rotatable platform (350) is configured to be rotatable about the vertical direction (Z) to change an orientation of the element placed thereon.

18. The programmable digital machine vision inspection system according to claim 17,
wherein the rotatable platform (350) comprises a plurality of vacuum suction nozzles (351, 352) configured to suck and position the elements placed on the rotatable platform (350).
